(19) Europäisches Patentamt
European Patent Office
Office européen des brevets

(11) **EP 3 654 506 A1**

(12) **EUROPÄISCHE PATENTANMELDUNG**

(43) Veröffentlichungstag:
**20.05.2020 Patentblatt 2020/21**

(51) Int Cl.:
**H02M 1/32** (2007.01)  **H03K 17/082** (2006.01)

(21) Anmeldenummer: 18206763.7

(22) Anmeldetag: **16.11.2018**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **Siemens Aktiengesellschaft**
**80333 München (DE)**

(72) Erfinder:
• **Handt, Karsten**
  **92348 Berg (DE)**
• **Hänsel, Stefan**
  **91083 Baiersdorf (DE)**

(54) **ÜBERSTROMERKENNUNG EINES ELEKTRONISCHEN SCHALTERS**

(57) Die Erfindung betrifft ein Verfahren zur Erkennung eines Abschaltstromes durch einen elektronischen Schalter (1), wobei der elektronische Schalter (1) mindestens einen abschaltbaren Halbleiterschalter (2) aufweist, wobei der abschaltbare Halbleiterschalter (2) mindestens drei Anschlüsse (G,C,E) aufweist. Zur zuverlässigen Erkennung eines Überstroms für den elektronischen Schalter wird vorgeschlagen, dass eine Spannung ($U_{\text{Überstrom}}$) zwischen zwei der mindestens drei Anschlüsse (G,C,E) gemessen wird, wobei die Spannung ($U_{\text{Überstrom}}$) oder das zeitliche Integral der Spannung ($U_{\text{Überstrom}}$) mit einem Referenzwert ($X_{\text{ref}}$) verglichen wird und bei Überschreiten des Referenzwertes ($X_{\text{ref}}$) mindestens einer des mindestens einen abschaltbaren Halbleiterschalters (2) abgeschaltet wird. Ferner betrifft die Erfindung einen elektronischer Schalter (1) mit mindestens einem abschaltbaren Halbleiterschalter (2), wobei der abschaltbare Halbleiterschalter (2) mindestens drei Anschlüsse (G,C,E) aufweist, wobei der elektronische Schalter eine Spannungserfassung zur Messung einer Spannung ($U_{\text{Überstrom}}$) zwischen zwei der mindestens drei Anschlüsse (G,C,E) aufweist, wobei der elektronische Schalter (1) eine Auswerteeinheit (3) aufweist, wobei mittels der Auswerteeinheit die gemessene Spannung ($U_{\text{Überstrom}}$) mit einem Referenzwert ($X_{\text{ref}}$) vergleichbar ist, wobei mittels der Auswerteeinheit bei Überschreiten des Referenzwertes ($X_{\text{ref}}$) der mindestens eine abschaltbare Halbleiterschalter abschaltbar ist. Die Erfindung betrifft weiter ein Gleichspannungsnetz (4) mit einem derartigen elektronischen Schalter (1).

FIG 3

EP 3 654 506 A1

**Beschreibung**

Die Erfindung betrifft ein Verfahren zur Erkennung eines Abschaltstromes durch einen elektronischen Schalter, wobei der elektronische Schalter mindestens einen abschaltbaren Halbleiterschalter aufweist, wobei der abschaltbare Halbleiterschalter mindestens drei Anschlüsse aufweist. Ferner betrifft die Erfindung einen elektronischen Schalter mit mindestens einem abschaltbaren Halbleiterschalter, wobei der abschaltbare Halbleiterschalter mindestens drei Anschlüsse aufweist. Die Erfindung betrifft ferner ein Gleichspannungsnetz mit einem derartigen elektronischen Schalter.

Die Versorgung mit elektrischer Energie findet heutzutage in erster Linie über Wechselspannungsnetze statt. Diese haben den Vorteil, dass sich unterschiedliche Spannungsebenen mit Hilfe von Transformatoren herstellen lassen. Durch Halbleiter, die immer kostengünstiger am Markt verfügbar sind, lassen sich auch für Gleichspannungsnetze auf einfache Weise unterschiedliche Spannungsebenen erzeugen, so dass gerade auch die Energieversorgung über Gleichspannungsnetze, insbesondere innerhalb von Industrienetzen, besonders wirtschaftlich wird.

DC-Netze sollen dabei in zukünftigen Industrieanlagen Verluste reduzieren, den direkten Energieaustausch zwischen Umrichtern, Speichern und Motoren gewährleisten und eine erhöhte Robustheit erzielen. Dabei können beispielsweise kleine Gleichspannungsnetze, auch als Gleichspannungsnetze bezeichnet, mit unterschiedlichen Kabellängen zwischen den verschiedenen Lastabgängen und Einspeisungen betrieben werden. Gleichstromnetze können, im Vergleich zu Wechselstromnetzen, dabei eine deutlich größere Varianz in der Zuleitungsinduktivität und damit in dem Stromanstieg im Kurzschlussfall aufweisen, da hier einerseits keine Kurzschlussimpedanz eines vorgelagerten Transformators kurzschlussstrombegrenzend wirkt, sondern Energiespeicher in Form von kapazitiven Spannungszwischenkreisen als ideale Spannungsquellen sehr große Stromanstiege im Kurzschlussfall erzeugen können. Andererseits stellen sehr lange Zuleitungen nicht das Problem der zunehmenden Blindleistung durch Zunahme des Blindwiderstandes dar und somit sind große Reiheninduktivitäten durchaus zulässig, welche nur sehr kleine Stromanstiege im Kurzschluss zulassen, allerdings große Überspannungen beim Schalten verursachen.

Der Erfindung liegt die Aufgabe zugrunde, eine zuverlässige Überstromerkennung für einen elektronischen Schalter zu realisieren.

Diese Aufgabe wird durch ein Verfahren zur Erkennung eines Abschaltstromes durch einen elektronischen Schalter gelöst, wobei der elektronische Schalter mindestens einen abschaltbaren Halbleiterschalter aufweist, wobei der abschaltbare Halbleiterschalter mindestens drei Anschlüsse aufweist, wobei eine Spannung zwischen zwei der mindestens drei Anschlüsse gemessen wird, wobei die Spannung oder das zeitliche Integral der Spannung mit einem Referenzwert verglichen wird und bei Überschreiten des Referenzwertes mindestens einer des mindestens einen abschaltbaren Halbleiterschalters abgeschaltet wird. Ferner wird diese Aufgabe durch einen elektronischen Schalter mit mindestens einem abschaltbaren Halbleiterschalter gelöst, wobei der abschaltbare Halbleiterschalter mindestens drei Anschlüsse aufweist, wobei der elektronische Schalter eine Spannungserfassung zur Messung einer Spannung zwischen zwei der mindestens drei Anschlüsse aufweist, wobei der elektronische Schalter eine Auswerteeinheit aufweist, wobei mittels der Auswerteeinheit die gemessene Spannung mit einem Referenzwert vergleichbar ist, wobei mittels der Auswerteeinheit bei Überschreiten des Referenzwertes der mindestens eine abschaltbare Halbleiterschalter abschaltbar ist. Diese Aufgabe wird weiter durch ein Gleichspannungsnetz mit einem derartigen elektronischen Schalter gelöst.

Weitere vorteilhafte Ausgestaltungen der Erfindung sind in den abhängigen Ansprüchen angegeben.

Der Erfindung liegt die Erkenntnis zugrunde, dass derzeitige Stromwandler zur Messung des Stroms durch einen elektronischen Schalter, der sich in einem DC-Netz befindet, nur bedingt geeignet sind. Bekannte Arten von Gleichstromsensoren, wie beispielsweise Halleffekt- oder magnetoresistive Sensoren haben eine relativ geringe Grenzfrequenz, typischerweise im Bereich von 400kHz und Totzeiten im Bereich von 500ns bis 1500ns. Bei sehr niederinduktivem Netzen können in dieser Zeitspanne der Strom im Fehlerfall, wie beispielsweise einem Kurzschluss, sehr schnell hohe Werte erreichen, welche zur Zerstörung oder Fehlfunktion des Halbleiters führen können.

So kann in einem Beispiel bei einer Gleichspannung des Gleichspannungsnetzes von 800V und einer angenommenen Zuleitung von 2m Länge, die einer Induktivität von etwa $1\mu H$ entspricht, ein Stromanstieg von

$$i(t) = (U/L) * \Delta t = (800V/1\mu H) * 1,5\mu s = 1200A$$

entstehen. Somit sind die bekannten Stromwandler nur bedingt geeignet, einen zuverlässigen Schutz des elektronischen Schalters und der in dem Abgang des elektronischen Schalters angeordneten Komponenten in einem Gleichspannungsnetz sicherzustellen.

Es hat sich aber gezeigt, dass für den Schutz und damit für das Auslösen, d.h. Öffnen, des elektronischen Schalters, vielmehr ein schnelles Ansprechen der Stromdetektion wichtig ist als eine hohe Genauigkeit. ES hat sich gezeigt, dass durch das Messen von Spannungen am abschaltbaren Halbleiterschalter sehr schnell ein unzulässig hoher Strom erkannt werden kann, der vom elektronischen Schalter abzuschalten ist.

Es hat sich darüber hinaus gezeigt, dass man durch das Messen von Spannungen an den Anschlüssen des abschaltbaren Halbleiters einen hohen Strom bzw. einen hohen Stromanstieg zuverlässig erkennen kann.

Der abschaltbare Halbleiterschalter hat mindestens drei Anschlüsse. Bei Halbleitern auf der Basis von Transistoren wie IGBTs werden diese Anschlüsse als Gate (G), Kollektor (C) und Emitter (E) bezeichnet, bei einem MOSFET als Gate, Drain und Source. Dies erfindungsgemäße Verfahren funktioniert sowohl für abschaltbare Halbleiter mit Gate (G), Kollektor (C) und Emitter (E) als auch mit Gate, Drain und Source. Dabei entspricht der Gate Anschluss des IGBT dem Gate Anschluss des MOSFETs, der Kollektor Anschluss dem Drain Anschluss und der Emitter Anschluss dem Source Anschluss. Im Folgenden wird nicht mehr auf die Anschlüsse Gate, Drain und Source eingegangen. Jedoch sind die Ausführungen bezüglich Gate (G), Kollektor (C) und Emitter (E) in Bezug auf die Überstromerkennung ohne weiteres für sämtliche Ausführungsbeispiele auf die Anschlüsse Gate, Drain und Source übertragbar. Gleiches gilt für den später eingeführten Anschluss des Hilfsemitters.

Es hat sich gezeigt, dass sich hohe Ströme bzw. große Anstiegsgeschwindigkeiten von Strömen durch die Spannungen zwischen zwei der Anschlüsse des abschaltbaren Halbleiterschalters zuverlässig erkennen lassen. Übersteigt der gemessene Wert oder das Integral des gemessenen Wertes einen Referenzwert, auch als Grenzwert bezeichnet, so geht der abschaltbare Halbleiterschalter in den nichtleitenden Zustand über und der elektronische Schalter ist geöffnet. Der Referenzwert bzw. Grenzwert kann dabei vorgegeben und in der Auswerteeinheit abgelegt werden. Mittels der Auswerteeinheit wird der Messwert der Spannung bzw. sein Integral mit dem Referenzwert verglichen.

Während mit einer Messung der Spannung zwischen Kollektor und Emitter ein Strom durch den Halbleiter erkennbar ist, ist mit einer Messung zwischen dem Emitter und einem Hilfsemitter als vierter Anschluss des abschaltbaren Halbleiterschalters der Stromanstieg durch den abschaltbaren Halbleiter messbar. Dieser kann bereits für den Schutz durch Vergleich mit dem Referenzwert herangezogen werden, da anhand eines großen Stromanstiegs bereits ein Kurzschluss zuverlässig erkannt wird. Will man hingegen anstelle des Stromanstiegs das Abschalten des elektronischen Schalters bei Messung der Spannung zwischen Emitter und Hilfsemitter abhängig von der Stromhöhe gestalten, so ist anstelle des Spannungsmesswertes das zeitliche Integral über der gemessenen Spannung mit dem Referenzwert zu vergleich. Die Bildung des zeitlichen Integrals ist problemlos durch die Auswerteeinheit des elektronischen Schalters durchführbar.

Unter Abschalten eines abschaltbaren Halbleiterschalters wird verstanden, dass der abschaltbare Halbleiterschalter in den nichtleitenden Zustand versetzt wird.

Falls mehr als nur eine Spannung gemessen wird und/oder eine Spannung gemessen wird und sowohl der Wert der Messung als auch das zeitliche Integral für die Bestimmung des Abschaltkriteriums verwendet wird, können sich die Referenzwerte für den jeweiligen Vergleich unterscheiden.

Bei einer vorteilhaften Ausgestaltung der Erfindung wird die Spannung zwischen einem Kollektor-Anschluss und einem Emitter-Anschluss bzw. zwischen einem Drain-Anschluss und einem Source-Anschluss des mindestens einen abschaltbaren Halbleiterschalters gemessen. Hier wird die Kollektor-Emitter-Spannung ($U_{CE}$) bzw. die Drain-Source-Spannung ($U_{DS}$) im eingeschalteten Zustand des abschaltbaren Halbleiters gemessen. Bei einem hohen Strom durch den abschaltbareren Halbleiterschalter baut sich zwischen dem Kollektor- und dem Emitteranschluss eine Spannung auf. Wird diese größer als ein Referenzwert, oder auch als Grenzwert bezeichnet, wird dieser als Überstrom erkannt und der abschaltbare Halbleiterschalter abgeschaltet. Befindet sich der abschaltbare Halbleiterschalter bei Erreichen dieses Referenzwertes bereits in Sättigung, so ist der Überstrom besonders einfach zu erkennen, da die Spannung in diesem Bereich deutlich mit der Stromstärke ansteigt. Allerdings hat sich auch gezeigt, dass bereits vor der Sättigung die Spannung zwischen Kollektor und Emitter bereits mit dem Strom durch den Halbleiter ansteigt. Die messtechnische Erkennung einer solchen Spannungsänderung ist zwar schwieriger als im gesättigten Bereich, aber auf jeden Fall noch messtechnisch ermittelbar. Anhand der Kollektor-Emitter Spannung lässt sich auf einfache Weise und vor allem hinreichend schnell ein hoher Strom durch den abschaltbaren Halbleiterschalter erkennen und mit dem Abschalten des abschaltbaren Halbleiterschalters reagieren. Dieser hohe Strom kann beispielsweise seine Ursache in einem Kurzschluss haben, der aufgrund der geringen Induktivitäten im Gleichspannungsnetz schnell einen hohen Strom verursacht. Durch die schnelle Überstromerkennung durch das Messen der Kollektor-Emitter-Spannung kann der Überstrom und Vergleichen mit einem Referenzwert kann der Überstrom zuverlässig und schnell erkannt werden. Dadurch lassen sich die Vorteile des elektronischen Schalters, insbesondere seine schnelle Schaltzeit im Bereich von 100ns besonders vorteilhaft nutzen.

Besonders gut ist die Stromabbildung über die Spannung, wenn der abschaltbare Halbleiterschalter sich in Sättigung befindet. Daher eignet sich diese Ausführungsform insbesondere für Abschaltströme, die sich nahe an der Belastungsgrenze des abschaltbaren Halbleiters befinden.

Bei einer weiteren vorteilhaften Ausgestaltung der Erfindung weist der abschaltbare Halbleiterschalter mindestens vier Anschlüsse auf, wobei die Spannung zwischen dem Emitter-Anschluss und einem Hilfsemitter-Anschluss des mindestens einen abschaltbaren Halbleiterschalters gemessen wird. Hierbei weist der abschaltbare Halbleiterschalter als zusätzlichen Anschluss, d.h. als vierten Anschluss, einen Hilfsemitter, bzw. eine Hilfssource auf. Hierbei wird die Spannung zwischen dem Emitter bzw. Source, auch als Hauptemitter bezeichnet, und dem Hilfsemitter gemessen.

Fließt nun ein Strom mit einem sehr starken Anstieg durch die Kollektor-Emitter Strecke des abschaltbaren Halbleiterschalters, so fällt eine Spannung über eine Zuleitungsinduktivität $L_E$ im Innern des Halbleiters ab, welche proportional zum Stromanstieg ist. Integriert man diese gemessene Spannung, was digitaltechnisch sehr einfach realisierbar ist, erhält man einen Wert proportional zum Strom durch den abschaltbaren Halbleiterschalter. Ist darüber hinaus außerdem den Wert der Zuleitungsinduktivität $L_E$ bekannt, ist sogar der genaue Wert des Stromes berechenbar. Dieser ist aber nicht zwingend notwendig, man benötigt lediglich einen Referenzwert, welcher bei Überschreitung den Überstrom zuverlässig erkennt. Auch diese Methode kommt ohne Stromwandler aus und ist besonders schnell, so dass schnell ansteigende Ströme sicher und zuverlässig sowie besonders schnell erkannt werden können. Dadurch lassen sich auch durch diese Ausführungsform die Vorteile des elektronischen Schalters, insbesondere seine schnelle Schaltzeit im Bereich von 100ns, besonders vorteilhaft nutzen.

Darüber hinaus ist dieses Verfahren über die Messung der Spannung zwischen Emitter und Hilfsemitter auch dann mit einfachen Spannungssensoren durchführbar, wenn sich der Halbleiter noch nicht in Sättigung befindet. Damit eignet sich dieses Verfahren im Besonderen für Abschaltströme, die deutlich Unterhalb der Belastungsgrenze des abschaltbaren Halbleiterschalters liegen.

Weiterhin hat es sich als vorteilhaft erwiesen, auch eine klassische Strommessung über einen Stromsensor durchzuführen, da man so langsam ansteigende Stromanstiege detektieren kann. Diese Strommessung kann dann in Kombination mit der Erkennung über gemessene Spannungen zwischen Kollektor und Emitter und über eine Messung zwischen Emitter und Hilfsemitter ein besonders sicherer Kurzschlussschutz für einen elektronischen Schalter über einen weiten Bereich an Reiheninduktivität, auch als Zuleitungsinduktivitäten bezeichnet, und Überstromszenarien realisiert werden. Dabei wird an dem abschaltbaren Halbleiter sowohl die Spannung zwischen Kollektor und Emitter als auch die Spannung zwischen Emitter und Hilfsemitter gemessen. Damit ergibt sich zusammen mit der relativ langsamen Messung über den Stromsensor ein dreistufiges Schutzkonzept zur Herstellung der Betriebssicherheit des elektronischen Schalters in allen bekannten Überstromfällen. Die Referenzwerte für den Vergleich mit den gemessenen Spannungen bzw. deren zeitlichen Integral können sich dabei für jede Messung unterscheiden.

Bei einer weiteren vorteilhaften Ausgestaltung der Erfindung weist der elektronische Schalter zwei abschaltbaren Halbleiterschalter auf, wobei an den zwei abschaltbaren Halbleiterschalter jeweils die Spannung zwischen zwei Anschlüssen gemessen wird, wobei bei Überschreiten des Referenzwertes der betreffende abschaltbare Halbleiterschalter abgeschaltet wird. Die zwei abschaltbaren Halbleiterschalter sind dabei so angeordnet, dass sie jeweils einen Strom mit unterschiedlicher Polarität durch den Schalter abschalten können. Wenn es sich bei den abschaltbaren Halbleiterschaltern um rückwärts sperrende Halbleiterschalter handelt, werden diese in einer Parallelschaltung angeordnet, bei der für jede Stromrichtung jeweils einer der beiden abschaltbaren Halbleiterschalter den Strom führen und abschalten kann. Diese Parallelschaltung wird auch als Antiparallelschaltung oder die Anordnung als antiparallel bezeichnet. Für den Fall, dass die abschaltbaren Halbleiterschalter rückwärts leitfähig sind, erkennbar im Schaltbild an einer Diode, die antiparallel zum schaltenden Element angeordnet ist, so werden die beiden abschaltbaren Halbleiterschalter in einer Reihenschaltung angeordnet, bei dem in einer Stromrichtung der Strom durch das schaltende Element des ersten der beiden abschaltbaren Halbleiterschalter fließt und durch die Diode des zweiten der beiden abschaltbaren Halbleiterschalter. Bei entgegengesetzter Stromrichtung, d.h. bei entgegengesetzter Polarität des Stromes fließt der Strom durch das schaltende Element des zweiten der beiden abschaltbaren Halbleiterschalter und durch die Diode des ersten der beiden abschaltbaren Halbleiterschalter. Diese Anordnung wird auch als antiseriell bezeichnet. An beiden der abschaltbaren Halbleiterschalter kann dann an zwei der Anschlüsse die Spannung gemessen werden. Dies kann an den jeweils gleichen Anschlüssen oder auch an unterschiedlichen Anschlüssen geschehen. Ebenfalls kann der Referenzwert, d.h. der Grenzwert, mit der die gemessene Spannung verglichen wird, identisch sein oder sich unterscheiden. Dabei kann nach überschreiten des Referenzwert nur der betroffene abschaltbare Halbleiterschalter abgeschaltet werden oder es werden beide abschaltbaren Halbleiterschalter abgeschaltet.

Mit unterschiedlichen Referenzwerten kann damit auf einfache Weise ein richtungsabhängiger Schutz realisiert werden. Dabei ist der zulässige Strom in eine Richtung durch den elektronischen Schalter größer als in der anderen Richtung. Dann wird auch nur der abschaltbare Halbleiterschalter abgeschaltet, an dem der Referenzwert überschritten wird. Somit kann beispielsweise ein Kurzschlussschutz für die Lasten, die über den elektronischen Schalter mit der DC Quelle verbunden sind einen niedrigeren Grenzwert haben für den Strom von der Quelle zur Last, während bei umgekehrter Stromrichtung, also von der Last zur DC Quelle ein höherer Referenzwert vorgesehen wird, damit ein an anderer Stelle im Gleichspannungsnetz auftretender Kurzschluss nicht den elektronische Schalter ausschaltet, in Abgängen, in denen gar kein Kurzschluss vorhanden ist. Mit dieser Selektivität kann erreicht werden, dass schnell nur der von einem Kurzschluss betroffene Abgang abgeschaltet, während die elektronischen Schalter der übrigen Abgänge eingeschaltet bleiben, um die intakten Teile des Gleichspannungsnetzes weiter betriebsfähig zu halten auch wenn in diesen Teilen aufgrund des Kurzschlusses im anderen Abgang kurzzeitig ein höherer Strom fließt. Somit kann auf einfache Weise der Betrieb von nicht gestörten Teilen des Gleichspannungsnetzes weiter sichergestellt werden.

Besonders vorteilhaft ist, wie oben bereits dargestellt, der dreistufige Schutz für jeden der beiden abschaltbaren Halbleiterschalter. Dazu wird neben dem Stromsensor an beiden Halbleiterschaltern jeweils die Spannung zwischen Kollektor und Emitter sowie die Spannung Emitter und Hilfsemitter gemessen und mit jeweiligen Referenzwerten vergleichen. Dies bietet einen guten Schutz für alle erdenklichen Fehlerfälle im Gleichspannungsnetz.

Bei einer weiteren vorteilhaften Ausgestaltung der Erfindung weist ein erster der abschaltbare Halbleiterschalter mindestens vier Anschlüsse auf, wobei an dem ersten der zwei abschaltbaren Halbleiterschalter die Spannung zwischen einem Emitter-Anschluss und einem Hilfsemitter-Anschluss und an einem zweiten der zwei abschaltbaren Halbleiterschalter die Spannung zwischen einem Kollektor-Anschluss und einem Emitter-Anschluss gemessen wird. Dabei hat es sich als vorteilhaft erwiesen, wenn die Spannungserfassung zur Messung der Spannung zwischen einem Emitter-Anschluss und einem Hilfsemitter-Anschluss eines ersten der zwei abschaltbaren Halbleiterschalter und zur Messung der Spannung zwischen einem Kollektor-Anschluss und einem Emitter-Anschluss eines zweiten der zwei abschaltbaren Halbleiterschalter ausgelegt ist. Mit dieser Anordnung ist ein selektiver Schutz auf besonders einfache Weise möglich. Für den Abschaltstrom von der DC Quelle zur Last wird für den abschaltbaren Halbleiterschalter, der diesen Strom führen und abschalten kann ein geringerer Referenzwert, d.h. Grenzwert, vorgesehen. Dies geschieht über die Spannungsmessung an Emitter und Hilfsemitter. Diese ist in diesem Bereich des Abschaltstromes besonders günstig. Ebenfalls kann ein Auslösen hier bereits nicht bei Erreichen eines Stromwertes, sondern aufgrund der hohen Stromsteilheit, die typisch ist für einen Kurzschluss, vorgenommen werden. Die Auslösung aufgrund der hohen Steilheit erfolgt durch Vergleich der gemessenen Spannung mit dem Referenzwert. Die Auslösung aufgrund der Stromhöhe Steilheit erfolgt durch Vergleich des zeitlichen Integrals der gemessenen Spannung mit dem Referenzwert.

Für die entgegengesetzte Polarität wird an dem zweiten abschaltbaren Halbleiterschalter, der diesen Strom führen und abschalten kann die Spannung an Kollektor und Emitter gemessen. Aufgrund des höheren Abschaltstromes geht der abschaltbare Halbleiter dann bereits in Sättigung, so dass diese Messung ebenfalls mit hoher Genauigkeit durchgeführt werden kann. Für diese Richtung ist auch die Änderung des Stromes nicht von Bedeutung, so dass auf die Messung zwischen Emitter und Hilfsemitter verzichtet werden kann.

Im Folgenden wird die Erfindung anhand der in den Figuren dargestellten Ausführungsbeispielen näher beschrieben und erläutert. Es zeigen:

FIG 1 ein Gleichspannungsnetz mit einem elektronischen Schalter,
FIG 2 ein abschaltbaren Halbleiterschalter und
FIG 3 ein Ablaufdiagramm des Verfahrens zur Erkennung eines Abschaltstromes.

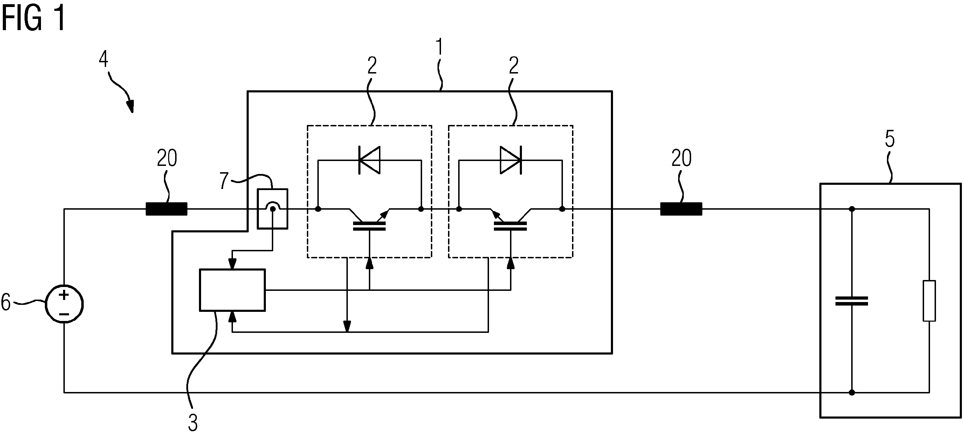

Die FIG 1 zeigt ein Gleichspannungsnetz 4 mit einer DC Quelle 6, die über einen elektronischen Schalter 1 eine Last 5 speist. Die einzelnen Leitungen in dem Gleichspannungsnetz weisen dabei eine Reiheninduktivität 20 auf, die zum einen die Anstiegsgeschwindigkeit des Stromes im Fehlerfall, wie beispielsweise einem Kurzschluss, begrenzen. Der elektronische Schalter 1 weist in diesem Ausführungsbeispiel zwei abschaltbare Halbleiterschalter 2 auf, die, weil rückwärts leitfähig, antiseriell angeordnet sind. Die beiden abschaltbaren Halbleiterschalter werden von einer Auswerteeinheit 3 angesteuert. Diese kann die einzelnen abschaltbaren Halbleiterschalter einschalten, d.h. den Halbleiter in den leitfähigen Zustand versetzen, oder abschalten, d.h. in den sperrenden Zustand versetzen. Um einen Überstrom zu erkennen verwendet die Auswerteeinheit Messwerte von zwei die Anschlüsse des jeweiligen abschaltbaren Halbleiterschalters 2. Zusätzlich kann, nicht notwendigerweise, auch noch das Signal eines Stromsensors 7 ausgewertet werden. Dieser Stromsensor kann sich innerhalb des elektronischen Schalters 1 oder außerhalb befinden.

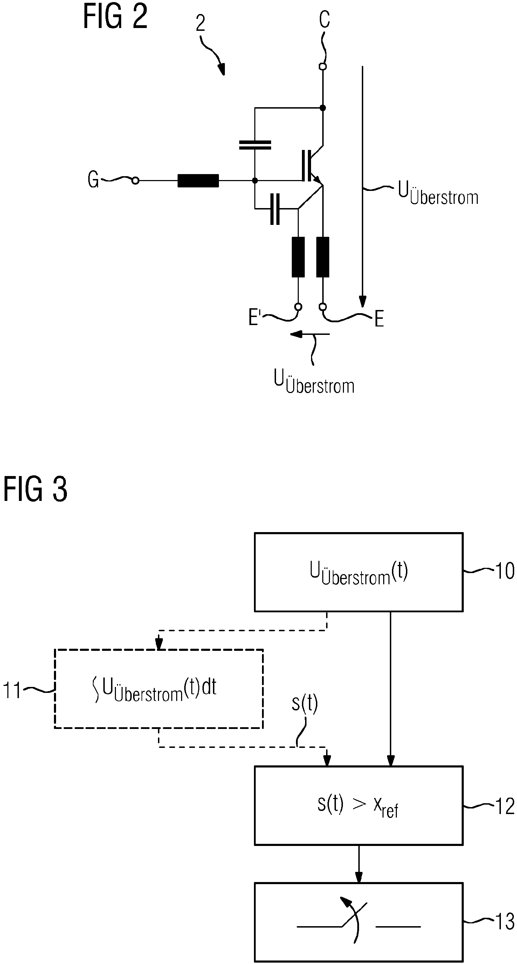

Die FIG 2 zeigt einen abschaltbaren Halbleiterschalter 2 mit seinen Anschlüssen Gate G, Kollektor C und Emitter E. Je nach verwendetem Verfahren zur Überstromerkennung wird auch noch ein vierter Anschluss, der Hilfsemitter E', benötigt. Der Strom durch den elektronischen Schalter fließt vom Kollektor C zum Emitter E. Der Hilfsemitter dient nur zum Messen der Spannung zwischen Emitter und Hilfsemitter, wird jedoch nicht zum Führen des Stromes durch den abschaltbaren Halbleiterschalter verwendet. Zur Erkennung eines Überstroms kann nun die Spannung $U_{Überstrom}$ zwischen Kollektor C und Emitter E gemessen werden. Alternativ ist es möglich, auch die Spannung $U_{Überstrom}$ zwischen dem Emitter und dem Hilfsemitter zu messen. Auch die Kombination, d.h. die Messung beider Spannungen kann durchgeführt werden, um damit den Schutz redundant zu gestalten und auf unterschiedliche Fehlerfälle besser reagieren zu können.

Die FIG 3 zeigt den Ablauf des Verfahrens zur Erkennung eines Überstroms. Dabei wird in einem ersten Schritt 10 die Spannung $U_{Überstrom}$ zwischen zwei der Anschlüsse C, E, E' des abschaltbaren Halbleiterschalters 2 gemessen. Dieses Signal s(t) wird dann direkt zum Vergleich 12 mit einem Referenzwert $X_{ref}$ verwendet. Alternativ oder ergänzend kann der Wert der gemessenen Spannung $U_{Überstrom}$, gestrichelt dargestellt, auch über die Zeit integriert werden. D.h., es wird das zeitliche Integral über die gemessene Spannung $U_{Überstrom}$ gebildet. Auch dieses Signal s(t) wird dann dem Vergleich 12 mit einem Referenzwert $X_{ref}$ zugeführt. Dabei können aus der Messung der Spannung $U_{Überstrom}$ der Messwert an sich und/oder das zeitliche Integral der Spannung $U_{Überstrom}$ dem Vergleich 12 mit dem Referenzwert $X_{ref}$ zugeführt werden. Stellt sich bei dem Vergleich 12 heraus, dass das Signal s(t) größer ist als der zugehörige Referenzwert $X_{ref}$, so wird der betreffende abschaltbare Halbleiterschalter, an dem die Spannung $U_{Überstrom}$ gemessen wurde, oder beide Halbleiterschalter abgeschaltet 13, d.h. in den sperrenden Zustand versetzt. Angedeutet ist dies über das Symbol eines sich öffnenden mechanischen Schalters.

Diese Überwachung findet kontinuierlich statt, vorzugsweise in der oben beschriebenen Auswerteeinheit 3.

Zusammenfassend betrifft die Erfindung ein Verfahren zur Erkennung eines Abschaltstromes durch einen elektronischen Schalter, wobei der elektronische Schalter mindestens einen abschaltbaren Halbleiterschalter aufweist, wobei der abschaltbare Halbleiterschalte mindestens drei Anschlüsse aufweist. Zur zuverlässigen Erkennung eines Überstroms für den elektronischen Schalter wird vorgeschlagen, dass eine Spannung zwischen zwei der mindestens drei Anschlüsse gemessen wird, wobei die Spannung oder das zeitliche Integral der Spannung mit einem Referenzwert verglichen wird und bei Überschreiten des Referenzwertes mindestens einer des mindestens einen abschaltbaren Halbleiterschalters abgeschaltet wird. Ferner betrifft die Erfindung einen elektronischer Schalter mit mindestens einem abschaltbaren Halbleiterschalter, wobei der abschaltbare Halbleiterschalter mindestens drei Anschlüsse aufweist, wobei der elektronische Schalter eine Spannungserfassung zur Messung einer Spannung zwischen zwei der mindestens drei Anschlüsse aufweist, wobei der elektronische Schalter eine Auswerteeinheit aufweist, wobei mittels der Auswerteeinheit die gemessene Spannung mit einem Referenzwert ($X_{ref}$) vergleichbar ist, wobei mittels der Auswerteeinheit bei Überschreiten des Referenzwertes der mindestens eine abschaltbare Halbleiterschalter abschaltbar ist. Die Erfindung betrifft weiter ein Gleichspannungsnetz mit einem derartigen elektronischen Schalter.

**Patentansprüche**

1. Verfahren zur Erkennung eines Abschaltstromes durch einen elektronischen Schalter (1), wobei der elektronische Schalter (1) mindestens einen abschaltbaren Halbleiterschalter (2) aufweist, wobei der abschaltbare Halbleiterschalter (2) mindestens drei Anschlüsse (G,C,E) aufweist, wobei eine Spannung ($U_{Überstrom}$) zwischen zwei der mindestens drei Anschlüsse (G,C,E) gemessen wird, wobei die Spannung ($U_{Überstrom}$) oder das zeitliche Integral der Spannung ($U_{Überstrom}$) mit einem Referenzwert ($X_{ref}$) verglichen wird und bei Überschreiten des Referenzwertes ($X_{ref}$) mindestens einer des mindestens einen abschaltbaren Halbleiterschalters (2) abgeschaltet wird.

2. Verfahren nach Anspruch 1, wobei die Spannung ($U_{Überstrom}$) zwischen einem Kollektor-Anschluss (C) und einem Emitter-Anschluss (E) bzw. zwischen einem Drain-Anschluss und einem Source-Anschluss des mindestens einen abschaltbaren Halbleiterschalters (2) gemessen wird.

3. Verfahren nach einem der Anspruch 1 oder 2, wobei der abschaltbare Halbleiterschalter (2) mindestens vier Anschlüsse (G,C,E,E') aufweist, wobei die Spannung ($U_{Überstrom}$) zwischen dem Emitter-Anschluss (E) und einem Hilfsemitter-Anschluss (E') des mindestens einen abschaltbaren Halbleiterschalters (2) gemessen wird.

4. Verfahren nach einem der Ansprüche 1 bis 3, wobei der elektronische Schalter zwei abschaltbaren Halbleiterschalter (2) aufweist, wobei an den zwei abschaltbaren Halbleiterschalter (2) jeweils die Spannung ($U_{Überstrom}$) zwischen zwei Anschlüssen gemessen wird, wobei bei Überschreiten des Referenzwertes ($X_{ref}$) der betreffende abschaltbare Halbleiterschalter (2) abgeschaltet wird.

5. Verfahren nach Anspruch 4, wobei ein erster der abschaltbare Halbleiterschalter (2) mindestens vier Anschlüsse (G,C,E,E') aufweist, wobei an dem ersten der zwei abschaltbaren Halbleiterschalter (2) die Spannung ($U_{Überstrom}$) zwischen einem Emitter-Anschluss (E) und einem Hilfsemitter-Anschluss (E') und an einem zweiten der zwei abschaltbaren Halbleiterschalter (2) die Spannung ($U_{Überstrom}$) zwischen einem Kollektor-Anschluss (C) und einem Emitter-Anschluss (E) gemessen wird.

6. Verfahren nach einem der Ansprüche 1 bis 5, wobei ein Stromsensor als Mittel zur Stromerfassung verwendet wird, wobei unabhängig von der gemessenen Spannung ($U_{Überstrom}$) zwischen zwei der mindestens drei Anschlüsse der abschaltbare Halbleiterschalter oder die abschaltbaren Halbleiterschalter geöffnet werden, wenn der durch den Stromsensor erfasste Wert einen Grenzwert überschreitet.

7. Elektronischer Schalter (1) mit mindestens einem abschaltbaren Halbleiterschalter (2), wobei der abschaltbare Halbleiterschalter (2) mindestens drei Anschlüsse (G,C,E) aufweist, wobei der elektronische Schalter eine Spannungserfassung zur Messung einer Spannung ($U_{Überstrom}$) zwischen zwei der mindestens drei Anschlüsse (G,C,E) aufweist, wobei der elektronische Schalter (1) eine Auswerteeinheit (3) aufweist, wobei mittels der Auswerteeinheit die gemessene Spannung ($U_{Über-strom}$) mit einem Referenzwert ($X_{ref}$) vergleichbar ist, wobei mittels der Auswerteeinheit bei Überschreiten des Referenzwertes ($X_{ref}$) der mindestens eine abschaltbare Halbleiterschalter abschaltbar ist.

8. Elektronischer Schalter (1) nach Anspruch 7, wobei der elektronische Schalter (1) zwei abschaltbare Halbleiterschalter (2) aufweist.

9. Elektronischer Schalter (1) nach Anspruch 8, wobei ein erster der abschaltbare Halbleiterschalter (2) mindestens vier Anschlüsse (G,C,E,E') aufweist, wobei die Spannungserfassung zur Messung der Spannung ($U_{\text{Überstrom}}$) zwischen einem Emitter-Anschluss (E) und einem Hilfsemitter-Anschluss (E') eines ersten der zwei abschaltbaren Halbleiterschalter (2) und zur Messung der Spannung ($U_{\text{Überstrom}}$) zwischen einem Kollektor-Anschluss (C) und einem Emitter-Anschluss (E) eines zweiten der zwei abschaltbaren Halbleiterschalter (2) ausgelegt ist.

10. Gleichspannungsnetz (4) mit einem elektronischen Schalter (1) nach einem der Ansprüche 7 bis 9.

FIG 1

EP 3 654 506 A1

## FIG 2

## FIG 3

**Europäisches Patentamt**
**European Patent Office**
**Office européen des brevets**

## EUROPÄISCHER RECHERCHENBERICHT

**Nummer der Anmeldung**

EP 18 20 6763

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2013/063188 A1 (SOGO NAOHIRO [JP] ET AL) 14. März 2013 (2013-03-14) | 1-3,6,7 | INV. H02M1/32 |
| Y | * Absätze [0009], [0057], [0059], [0060], [0077], [0078]; Abbildungen 1-12 * | 4,5,8-10 | H03K17/082 |
| | ----- | | |
| X | EP 3 118 995 A1 (LSIS CO LTD [KR]) 18. Januar 2017 (2017-01-18) | 1,2,7 | |
| Y | * Absätze [0043], [0047], [0055] - [0057]; Abbildung 2 * | 4,5,8-10 | |
| | ----- | | |
| X | US 2015/326222 A1 (NIEMI MIKA [FI] ET AL) 12. November 2015 (2015-11-12) * Absätze [0033], [0046], [0066], [0075]; Abbildungen 1-3 * | 1-3,7 | |
| | ----- | | |
| X | KR 101 085 864 B1 (SHINWOO POWER TECHNOLOGI CO LTD [KR]; KUK JE ELECTRIC MFG CO LTD [KR]) 22. November 2011 (2011-11-22) * Zusammenfassung; Abbildungen 1,2 * | 1,2,7 | |
| | ----- | | **RECHERCHIERTE SACHGEBIETE (IPC)** |
| X | DE 102 10 181 C1 (SEMIKRON ELEKTRONIK GMBH [DE]) 17. Juli 2003 (2003-07-17) * Absatz [0010]; Abbildung 2 * | 1,2,7 | H02M H03K |
| | ----- | | |
| A | EP 2 444 817 A2 (FUJI ELECTRIC CO LTD [JP]) 25. April 2012 (2012-04-25) * Abbildungen 6A, 6B, 8, 9 * | 1-10 | |
| | ----- | | |

Der vorliegende Recherchenbericht wurde für alle Patentansprüche erstellt

| Recherchenort | Abschlußdatum der Recherche | Prüfer |
|---|---|---|
| Den Haag | 15. Mai 2019 | Kanelis, Konstantin |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

...............................................................
& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 18 20 6763

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-05-2019

| Im Recherchenbericht angeführtes Patentdokument | Datum der Veröffentlichung | Mitglied(er) der Patentfamilie | Datum der Veröffentlichung |
|---|---|---|---|
| US 2013063188 A1 | 14-03-2013 | CN 103001611 A | 27-03-2013 |
| | | DE 102012216317 A1 | 14-03-2013 |
| | | JP 5645782 B2 | 24-12-2014 |
| | | JP 2013062730 A | 04-04-2013 |
| | | US 2013063188 A1 | 14-03-2013 |
| EP 3118995 A1 | 18-01-2017 | CN 106357256 A | 25-01-2017 |
| | | EP 3118995 A1 | 18-01-2017 |
| | | JP 2017028988 A | 02-02-2017 |
| | | KR 20170009126 A | 25-01-2017 |
| | | US 2017019099 A1 | 19-01-2017 |
| US 2015326222 A1 | 12-11-2015 | CN 105099417 A | 25-11-2015 |
| | | DK 2942870 T3 | 22-10-2018 |
| | | EP 2942870 A1 | 11-11-2015 |
| | | US 2015326222 A1 | 12-11-2015 |
| KR 101085864 B1 | 22-11-2011 | KEINE | |
| DE 10210181 C1 | 17-07-2003 | AT 397805 T | 15-06-2008 |
| | | DE 10210181 C1 | 17-07-2003 |
| | | DK 1367716 T3 | 15-09-2008 |
| | | EP 1367716 A1 | 03-12-2003 |
| | | ES 2306819 T3 | 16-11-2008 |
| EP 2444817 A2 | 25-04-2012 | CN 102455382 A | 16-05-2012 |
| | | EP 2444817 A2 | 25-04-2012 |
| | | JP 5170208 B2 | 27-03-2013 |
| | | JP 2012090499 A | 10-05-2012 |
| | | US 2012098573 A1 | 26-04-2012 |

EPO FORM P0461

Für nähere Einzelheiten zu diesem Anhang : siehe Amtsblatt des Europäischen Patentamts, Nr.12/82